# EUROPEAN PATENT APPLICATION

(11) **EP 4 174 958 A1**
(43) Date of publication of application: **03.05.2023**
(21) Application number: 21893120.2
(22) Date of filing: 29.12.2021
(51) Int. Cl.: H01L 31/0224, H01L 31/074

(54) **TRANSPARENT CONDUCTIVE OXIDE THIN FILM AND HETEROJUNCTION SOLAR CELL**

(30) Priority: 15.09.2021 CN 202111080593
(71) Applicant: Zhongwei New Energy (Chengdu) Co., Ltd., Chengdu, Sichuan 610225 (CN)
(72) Inventor: SHI, Jianhua, Chengdu City Sichuan 610299 (CN); ZHANG, Haichuan, Chengdu City Sichuan 610299 (CN); YUAN, Qiang, Chengdu City Sichuan 610299 (CN); MENG, Chuncai, Chengdu City Sichuan 610299 (CN); MENG, Fanying, Chengdu City Sichuan 610299 (CN); LIU, Zhengxin, Chengdu City Sichuan 610299 (CN); CHENG, Qiong, Chengdu City Sichuan 610299 (CN); ZHOU, Hua, Chengdu City Sichuan 610299 (CN); ZHOU, Dan, Chengdu City Sichuan 610299 (CN)
(74) Representative: Romano, Giuseppe
(86) International application number: PCT/CN2021/142673
(87) International publication number: WO 2023/040120

(57) **Abstract**

The present application provides a transparent conductive oxide film and a heterojunction solar cell, which relates to the technical field of solar cells. The transparent conductive oxide film includes a seed layer, a conductive layer and a protection layer. The seed layer includes an indium tin oxide film or a gallium/aluminum co-doped zinc oxide film. The conductive layer is a gallium/aluminum co-doped zinc oxide film. The protection layer is an indium tin oxide film. The thickness of the indium tin oxide film in the transparent conductive oxide film is smaller than the thickness of the gallium/aluminum co-doped zinc oxide film. It can ensure battery efficiency and reduce battery attenuation, while reducing costs.

## Description

### Cross-Reference to Related Applications

The present application requires the priority of the Chinese patent application filed with the State Intellectual Property Office of China on September 15, 2021, with the application number of 202111080593.3, entitled as "Transparent Conductive Oxide Film and Heterojunction Solar Cell", all of which is incorporated in the present application by reference.

### Technical Field

The present application relates to the technical field of solar cells, and in particular, to a transparent conductive oxide film and a heterojunction solar cell.

### Background Art

Transparent conductive oxide (TCO) films, thanks to their excellent photoelectric properties, have been widely used in fields related to photoelectric semiconductors, such as low-E glass, flat panel displays, light-emitting diodes, photodetectors, optoelectronic communications, and solar cells, etc.

In applications of heterojunction solar cells (SHJ), TCO films have three important functions: 1, acting as an effective collecting and transporting carrier for photogenerated carriers, which requires good electrical conductivity; 2, acting as a surface anti-reflection window layer; and 3, acting as a surface protection layer. In addition, as for the TCO film, besides that the photoelectric properties required for meeting the battery performance are needed, it is also needed to strictly control the material and preparation costs of the TCO film.

Here, the indium tin oxide (ITO) film is a commonly used TCO film, but the current price of indium is relatively high, resulting in the relatively high cost of indium tin oxide (ITO) films. The aluminum-doped zinc oxide (AZO) film is another commonly used TCO film. Because the main components of the film are Zn and Al, its cost is only about 1/10 of the ITO film. In the prior art, in order to reduce the cost, the AZO film of low cost is used to replace the ITO film, but the efficiency of using the AZO film as the TCO film to prepare the SHJ cell is low and the problem of battery attenuation is serious, and the end product is difficult to meet the related index requirements of the national standards committee IEC: 61215.

### Summary

Embodiments of the present application provide a transparent conductive oxide film and a heterojunction solar cell, which can ensure battery efficiency, reduce the battery attenuation, and reduce costs.

The embodiments of the present application are implemented as follows.

Some Embodiments of the present application provide a transparent conductive oxide film, which may comprises a seed layer, a conductive layer and a protection layer, wherein the seed layer may comprise an indium tin oxide film or a gallium/aluminum co-doped zinc oxide film, the conductive layer may be a gallium/aluminum co-doped zinc oxide film, and the protection layer may be an indium tin oxide film; and
the indium tin oxide film in the transparent conductive oxide film may have a thickness smaller than that of the gallium/aluminum co-doped zinc oxide film.

Other embodiments of the present application provide a heterojunction solar cell, which may comprise:
a silicon wafer;
intrinsic amorphous silicon films, on both surfaces of the silicon wafer;
a P-type doped amorphous silicon film and an N-type doped amorphous silicon film, with the P-type doped amorphous silicon film located on a surface of one of the intrinsic amorphous silicon films, and the N-type doped amorphous silicon film located on a surface of the other intrinsic amorphous silicon film;
the transparent conductive oxide film of some embodiments of the present application, wherein the transparent conductive oxide film may be provided on surfaces of the P-type doped amorphous silicon film and the N-type doped amorphous silicon film, and the seed layer is provided close to the P-type doped amorphous silicon film and the N-type doped amorphous silicon film; and
an electrode, which may be arranged on a surface of the transparent conductive oxide film.

Optionally, the silicon wafer may be a single crystal silicon wafer.

Optionally, in the transparent conductive oxide film on the surface of the N-type doped amorphous silicon film, the seed layer may have a carrier concentration > 6 × 10²⁰, and a thickness <10nm.

Optionally, in the transparent conductive oxide film on the surface of the N-type doped amorphous silicon film, the conductive layer may have a carrier concentration < 2×10²⁰, and a thickness > 40nm.

Optionally, the transparent conductive oxide film on the surface of the N-type doped amorphous silicon film may have a thickness of 60nm - 150nm.

Optionally, in the transparent conductive oxide film on the surface of the P-type doped amorphous silicon film, the seed layer may have a carrier concentration <1×10²⁰, and a thickness <10nm.

Optionally, in the transparent conductive oxide film on the surface of the P-type doped amorphous silicon film, the conductive layer may have a carrier concentration >3×10²⁰, and a thickness>40nm.

Optionally, the transparent conductive oxide film on the surface of the P-type doped amorphous silicon film may have a thickness of 60nm - 250nm.

Optionally, both the P-type doped amorphous silicon film and the N-type doped amorphous silicon film may have microcrystalline silicon.

Optionally, the P-type doped amorphous silicon film may have a crystallization rate > 20%; and/or the N-type doped amorphous silicon film may have a crystallization rate > 25%.

Optionally, the P-type doped amorphous silicon film and the N-type doped amorphous silicon film may contain no microcrystalline silicon.

Optionally, in the transparent oxide film on the surface of the N-type doped amorphous silicon film, the seed layer may have a carrier concentration of 5×10²⁰, and a thickness of 12nm, or the conductive layer has a carrier concentration of 3×10²⁰ and a thickness of 35nm.

Optionally, in the transparent oxide film on the surface of the P-type doped amorphous silicon film, the seed layer may have a carrier concentration of 1.5×10²⁰ and a thickness of 12nm, or the conductive layer has a carrier concentration of 2.5×10²⁰ and a thickness is 35nm.

The beneficial effects of the transparent conductive oxide film and the heterojunction solar cell of the embodiments of the present application at last comprise the follows.

The seed layer in the transparent conductive oxide film comprises indium tin oxide film or gallium/aluminum co-doped zinc oxide film. The seed layer can reduce the contact potential barrier between the transparent conductive oxide film and the P-type doped amorphous silicon film and the N-type doped amorphous silicon film, to obtain lower contact resistance. At the same time, the indium tin oxide film is used as a protection layer, which can improve the stability of the transparent conductive oxide film, ensure battery efficiency and reduce battery attenuation, wherein the conductive layer is a gallium/aluminum co-doped zinc oxide film, and the thickness of the indium tin oxide film in the transparent conductive oxide film is smaller than that of the gallium/aluminum co-doped zinc oxide film, which can reduce costs.

### Brief Description of Drawings

In order to more clearly describe the technical solutions of the embodiments of the present application, the drawings needed to be used in the embodiments will be briefly introduced as follows. It should be understood that the following drawings only show some embodiments of the present application, and therefore should not be regarded as a limitation on the scope. For those ordinarily skilled in the art, other related drawings can also be obtained according to these drawings without any creative effort.
FIG. 1 is a schematic structural diagram of a heterojunction solar cell according to an embodiment of the present application; and
FIG. 2 is a schematic structural diagram of a transparent conductive oxide film according to an embodiment of the present application.

Reference Numbers: 10-heterojunction solar cell; 11-silicon wafer; 12-intrinsic amorphous silicon film; 13-P-type doped amorphous silicon film; 14-N-type doped amorphous silicon film; 15-transparent conductive oxide film; 151-seed layer; 152-conductive layer; 153-protection layer; and 16-electrode.

### Detailed Description of Embodiments

The embodiments of the present application will be described in detail below with reference to embodiments, but those skilled in the art will understand that the following embodiments are only used to illustrate the present application and should not be regarded as limiting the scope of the present application. If specific conditions are not indicated in the embodiments, it is carried out according to the conventional conditions or the conditions suggested by the manufacturer. The used reagents or instruments without the manufacturer indicated are conventional products that can be purchased from the market.

The transparent conductive oxide film 15 and the heterojunction solar cell 10 of the embodiments of the present application are described in detail as follows.

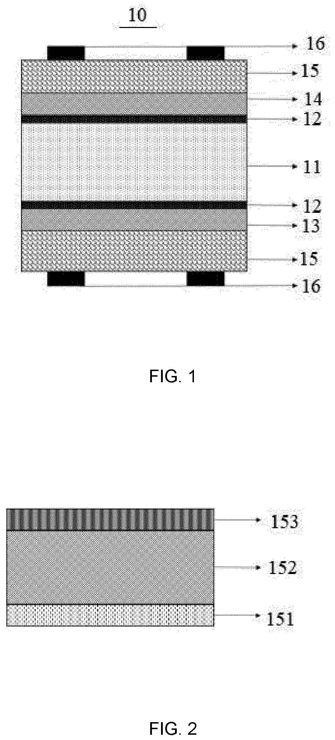

Some embodiments of the present application provide a transparent conductive oxide film 15. Referring to FIG. 2, it may comprise a seed layer 151, a conductive layer 152 and a protection layer 153, wherein the seed layer 151 may comprise an indium tin oxide (ITO) film or a gallium/aluminum co-doped zinc oxide (GAZO) film, the conductive layer 152 may be a gallium/aluminum co-doped zinc oxide film, and the protection layer 153 may be an indium tin oxide film.

The seed layer 151 in the transparent conductive oxide film 15 may comprise an indium tin oxide film or a gallium/aluminum co-doped zinc oxide film. The seed layer 151 can reduce the contact potential barrier between the transparent conductive oxide film 15 and the doped amorphous silicon film in the solar cell, to obtain the lower contact resistance. At the same time, the indium tin oxide film is used as the protection layer 153, which can improve the stability of the transparent conductive oxide film 15, ensure the battery efficiency and reduce the battery attenuation. Since the cost of the gallium/aluminum co-doped zinc oxide film is lower than that of the indium tin oxide film, when the conductive layer 152 is a gallium/aluminum co-doped zinc oxide film and the indium tin oxide film in the transparent conductive oxide film 15 has the thickness smaller than the thickness of the gallium/aluminum co-doped zinc oxide film, the cost can be effectively reduced.

The inventor of the present application found in research that if an indium tin oxide film is used as the conductive layer 152 and a gallium/aluminum co-doped zinc oxide film is used as the protection layer 153, the stability of the transparent conductive oxide film 15 is low, which affects the battery efficiency, resulting in the battery attenuation more serious.

It should be noted that when the seed layer 151 comprises an indium tin oxide film, the thickness of the indium tin oxide film in the transparent conductive oxide film 15 is the sum of the thickness of the seed layer 151 and the thickness of the protection layer 153. When the seed layer 151 comprises a gallium/aluminum co-doped zinc oxide film, the thickness of the gallium/aluminum co-doped zinc oxide film in the transparent conductive oxide film 15 is the sum of the thickness of the seed layer 151 and the thickness of the conductive layer 152.

Exemplarily, the doping ratio of tin in the ITO film is not greater than 10wt%, for example, 1wt%, 2wt%, 3wt%, 4wt%, 5wt%, 6wt%, 7wt%, 8wt%, 9wt% or 10wt%.

It should be noted that, the indium tin oxide film in the transparent conductive oxide film 15 may be an indium tin oxide film with one tin doping ratio, or may be formed by stacking a plurality of layers of indium tin oxide films with different tin doping ratios.

Exemplarily, the aluminum doping ratio in the GAZO film is not greater than 3 wt%, for example, 0.5 wt%, 1 wt%, 0.5 wt%, 1.5 wt%, 2 wt%, 2.5 wt% or 3 wt%. Exemplarily, the doping ratio of gallium in the GAZO film is 0.5-3.5 wt%, for example, 0.5 wt%, 1 wt%, 1.5 wt%, 2 wt%, 0.5 wt%, 2.5 wt%, 3 wt% or 3.5 wt%.

It should be noted that the GAZO film in the transparent conductive oxide film 15 may be a GAZO film with one doping ratio, or may be formed by stacking a plurality of layers of GAZO films with different doping ratios.

Other embodiments of the present application provide a heterojunction solar cell 10. Referring to FIG. 1, it may comprise:
a silicon wafer 11;
intrinsic amorphous silicon films 12, on both surfaces of the silicon wafer 11 ;
a P-type doped amorphous silicon film 13 on the surface of one of the intrinsic amorphous silicon films 12, and an N-type doped amorphous silicon film 14 on the surface of the other intrinsic amorphous silicon film 12;
the transparent conductive oxide films 15 according to the some embodiments of the present application, wherein the transparent conductive oxide films 15 may be provided on the surfaces of the P-type doped amorphous silicon film 13 and the N-type doped amorphous silicon film 14, and the seed layers 151 may be provided close to the P-type doped amorphous silicon film 13 and the N-type doped amorphous silicon film 14; and
electrodes 16, which may be provided on the surfaces of the transparent conductive oxide films 15.

Since the seed layer 151 in the transparent conductive oxide film 15 may comprise an indium tin oxide film or a gallium/aluminum co-doped zinc oxide film. The seed layer 151 can reduce the contact potential barrier between the transparent conductive oxide film 15 and the P-type doped amorphous silicon film 13 and the N-type doped amorphous silicon film 14, to obtain the lower contact resistance. The conductive layer 152 may be a gallium/aluminum co-doped zinc oxide film, which can reduce the cost. At the same time, the indium tin oxide film is used as the protection layer 153, which can improve the stability of the transparent conductive oxide film 15, ensure the battery efficiency, and reduce the battery attenuation.

In some embodiments, both the P-type doped amorphous silicon film 13 and the N-type doped amorphous silicon film 14 may have microcrystalline silicon therein.

That both the P-type doped amorphous silicon film 13 and the N-type doped amorphous silicon film 14 may have microcrystalline silicon, which makes the conductivity of the P-type doped amorphous silicon film 13 and the N-type doped amorphous silicon film 14 better, the activation energy smaller, the bombardment damage smaller, and the contact potential barrier between the P-type doped amorphous silicon film 13 and the N-type doped amorphous silicon film 14 and the TCO film lower, which is beneficial to reduce the contact resistance and improve the battery efficiency.

Exemplarily, the crystallization rate of the P-type doped amorphous silicon film 13 may be >20%, for example, may be 21%, 22%, 23%, 24%, 25%, 26%, 28% or 30%.

Exemplarily, the crystallization rate of the N-type doped amorphous silicon film 14 may be >25%, for example, 26%, 28%, 30%, 32%, 35% or 40%.

Optionally, the silicon wafer 11 may be a single crystal silicon wafer 11.

Optionally, in some embodiments, in the transparent conductive oxide film 15 on the surface of the N-type doped amorphous silicon film 14, the carrier concentration of the seed layer 151 may be >6 × 10²⁰, and the thickness may be <10nm.

Since the seed layer 151 may comprise the indium tin oxide film or the gallium/aluminum co-doped zinc oxide film and the carrier concentration of the seed layer 151 may be >6 × 10²⁰ and the thickness may be <10nm, it is possible to further reduce the contact potential barrier between the N-type doped amorphous silicon film 14 and the transparent conductive oxide film 15, so as to achieve the lower contact resistance, which is beneficial to further improve the battery efficiency.

Exemplarily, the carrier concentration of the seed layer 151 may be 6.2×10²⁰, 6.5×10²⁰, 7×10²⁰, 8×10²⁰, 9×10²⁰, or 10×10²⁰. Exemplarily, the thickness of the seed layer 151 may be 1nm, 3nm, 5nm, 7nm or 9nm.

In some embodiments, in the transparent conductive oxide film 15 on the surface of the N-type doped amorphous silicon film 14, the carrier concentration of the conductive layer 152 may be <2×10²⁰, and the thickness may be >40nm.

Since the conductive layer 152 is a GAZO film and the carrier concentration may be < 2×10²⁰ and the thickness may be >40nm, the parasitic absorption of the transparent conductive oxide film 15 can be reduced, thereby further improving the battery efficiency of the heterojunction solar cell 10 and reducing the battery attenuation.

Exemplarily, in the transparent conductive oxide film 15 on the surface of the N-type doped amorphous silicon film 14, the carrier concentration of the conductive layer 152 may be 0.2×10²⁰, 0.5×10²⁰, 0.8×10²⁰, 1×10²⁰, 1×10²⁰, 1.2×10²⁰, 1.5×10²⁰, or 1.8×10²⁰. Exemplarily, the thickness of the conductive layer 152 may be 42nm, 45nm, 50nm, 52nm or 55nm.

In some embodiments, in the transparent conductive oxide film 15 on the surface of the N-type doped amorphous silicon film 14, the thickness of the protection layer 153 may be 10-40nm, for example, 10nm, 20nm, 30nm or 40nm.

Optionally, the thickness of the transparent conductive oxide film 15 on the surface of the N-type doped amorphous silicon film 14 in the embodiment of the present application may be 60 to 150nm, for example, 60nm, 70nm, 80nm, 90nm, 100nm, 110nm, 120nm, 130nm, 140nm or 150nm.

Optionally, in some embodiments, in the transparent conductive oxide film 15 on the surface of the P-type doped amorphous silicon film 13, the carrier concentration of the seed layer 151 may be <1×10²⁰, and the thickness may be <10nm.

Since the seed layer 151 comprises an indium tin oxide film or a gallium/aluminum co-doped zinc oxide film and the carrier concentration of the seed layer 151 is <1×10²⁰ and the thickness is <10nm, the adaptation degree of the interface work function can be increased and the contact potential barrier between the P-type doped amorphous silicon film 13 and the transparent conductive oxide film 15 is further reduced, so as to obtain the lower contact resistance, which is beneficial to further improve the battery efficiency.

Exemplarily, in the transparent conductive oxide film 15 on the surface of the P-type doped amorphous silicon film 13, the carrier concentration of the seed layer 151 may be 0.2×10²⁰, 0.5×10²⁰, 0.8×10²⁰ or 0.9×10²⁰. Exemplarily, the thickness of the seed layer 151 may be 1nm, 3nm, 5nm, 7nm or 9nm.

In some embodiments, in the transparent conductive oxide film 15 on the surface of the P-type doped amorphous silicon film 13, the carrier concentration of the conductive layer 152 may be >3×10²⁰, and the thickness may be >40nm.

Since the conductive layer 152 is a GAZO film and the carrier concentration is >3×10²⁰ and the thickness is >40nm, the transparent conductive oxide film 15 can be ensured to have better conductivity.

Exemplarily, in the transparent conductive oxide film 15 on the surface of the P-type doped amorphous silicon film 13, the carrier concentration of the conductive layer 152 may be 3.2×10²⁰ , 3.5×10²⁰, 4×10²⁰, 4.5×10²⁰, 5×10²⁰ or 6×10²⁰. Exemplarily, the thickness of the conductive layer 152 may be 42nm, 45nm, 50nm, 52nm or 55nm.

In some embodiments, in the transparent conductive oxide film 15 on the surface of the P-type doped amorphous silicon film 13, the thickness of the protection layer 153 may be 10nm-40nm, for example, 10nm, 20nm, 30nm or 40nm.

Optionally, the thickness of the transparent conductive oxide film 15 on the surface of the P-type doped amorphous silicon film 13 in the embodiment of the present application is 60 to 250nm, for example, 60nm, 80nm, 100nm, 120nm, 150nm, 180nm, 200nm, 220nm or 250nm.

Embodiments of the present application also provide a process for preparing a heterojunction solar cell 10, which may comprise:
performing the surface texturing and the chemical cleaning on the silicon wafer 11, to form a surface light trapping structure;
depositing intrinsic amorphous silicon films 12 on both surfaces of the silicon wafer 11;
depositing a P-type doped amorphous silicon film 13 on the surface of one of the intrinsic amorphous silicon films 12, and depositing an N-type doped amorphous silicon film 14 on the surface of the other one of the intrinsic amorphous silicon films 12;
forming transparent conductive oxide films 15 on the surfaces of the P-type doped amorphous silicon film 13 and the N-type doped amorphous silicon film 14 by means of the laser sputtering coating; and
forming electrodes 16 on the surfaces of the transparent conductive oxide films 15 by screen printing.

The transparent conductive oxide film 15 and the heterojunction solar cell 10 of the present application will be further described in detail below with reference to the embodiments.

### Embodiment 1

The present embodiment provides a heterojunction solar cell, which can comprise:
a single crystal silicon wafer, intrinsic amorphous silicon films on both surfaces of the silicon wafer, a P-type doped amorphous silicon film on the surface of one of the intrinsic amorphous silicon films, a N-type doped amorphous silicon film on the surface of the other one of the intrinsic amorphous silicon films, TCO films and electrodes provided on the surfaces of the TCO films.

Here, the P-type doped amorphous silicon film may contain microcrystalline silicon, and its crystallization rate may be 20%. The N-type doped amorphous silicon film may contain microcrystalline silicon, and its crystallization rate may be 30%.

The TCO films may be arranged on the surfaces of the P-type doped amorphous silicon film and the N-type doped amorphous silicon film, wherein the TCO film on the surface of the N-type doped amorphous silicon film may comprise a seed layer with a thickness of 10nm, a conductive layer with a thickness of 60nm, and a protection layer with a thickness of 20nm, which were arranged sequentially. The seed layer may be an ITO film. The carrier concentration may be 8×10²⁰ . The conductive layer may be a GAZO film, the carrier concentration may be 1×10²⁰, and the protection layer may be an ITO film. Here, the TCO film on the surface of the P-type doped amorphous silicon film may comprise a seed layer with a thickness of 10nm, a conductive layer with a thickness of 60nm and a protection layer with a thickness of 20nm, which were arranged sequentially. The seed layer may be an ITO film and the carrier concentration may be 0.8×10²⁰ . The conductive layer may be a GAZO film and the carrier concentration may be 4×10²⁰. The protection layer may be an ITO film.

The seed layer of the TCO film was disposed close to the P-type doped amorphous silicon film and the N-type doped amorphous silicon film.

The present embodiment also provides a method for preparing a heterojunction solar cell, the steps of which may comprise:
(1) texturing and chemically cleaning the surface of the single crystal silicon wafer, using a single crystal silicon wafer as the substrate, to form a surface light trapping structure, and forming a clean surface after a chemical cleaning was performed again;
(2) depositing intrinsic amorphous silicon film respectively on two surfaces of a single crystal silicon wafer;
(3) depositing a P-type doped amorphous silicon film on the surface of one of the intrinsic amorphous silicon films, and depositing an N-type doped amorphous silicon film on the surface of the other one of the intrinsic amorphous silicon films, to complete the surface passivation and the field passivation;
(4) froming a TCO film on the surface of the P-type doped amorphous silicon film by means of magnetron sputtering coating, wherein the magnetron sputtering process condition of the seed layer of the TCO film comprised that: the sputtering target was ITO, the sputtering power density was 5KW/m, the sputtering pressure was 0.45Pa, the sputtering temperature was 180°C, and the volume ratio of oxygen/argon was 1.0%; the magnetron sputtering process condition of the conductive layer of the TCO film comprised that: the sputtering power density was 5KW/m, the sputtering pressure was 0.45Pa, the sputtering temperature was 180°C, and the volume ratio of oxygen/argon was 2%; and the magnetron sputtering process condition of the protection layer of the TCO film comprised that: the sputtering power density was 5KW /m, the sputtering pressure was 0.35 Pa, the sputtering temperature was 180° C, and the oxygen/argon ratio was 3.0%;
(5) forming a TCO film on the surface of the N-type doped amorphous silicon film by means of the magnetron sputtering coating, wherein the magnetron sputtering process condition of the seed layer of the TCO film comprised that: the sputtering target was ITO, the sputtering power density was 5KW/m, the sputtering pressure was 0.45Pa, the sputtering temperature was 180°C, and the volume ratio of oxygen/argon was 3.0%; the magnetron sputtering process condition of the conductive layer of the TCO film comprised that: the sputtering power density was 5KW/m, the sputtering pressure was 0.45Pa, the sputtering temperature was 180°C, the volume ratio of oxygen/argon was 2%; and the magnetron sputtering process condition of the protection layer of the TCO film comprised that: the sputtering power density was 5KW/m, the sputtering pressure was 0.35Pa, the sputtering temperature was 180°C, and the oxygen/argon ratio was 3.0%; and
(6) forming a metal electrode on the surface of the TCO film by screen printing.

### Embodiment 2

This embodiment provides a heterojunction solar cell. Compared with Embodiment 1, the difference only lies in that in the TCO films on the surfaces of the P-type doped amorphous silicon film and the N-type doped amorphous silicon film of this embodiment, the seed layer may be a GAZO film, and the thickness of the protection layer may be 10nm.

This embodiment also provides a method for preparing the heterojunction solar cell mentioned above. Compared with Embodiment 1, the difference only lies in that the ITO, as the sputtering target in the magnetron sputtering process condition of the seed layer in Step (5) and Step (6) in Embodiment 1, was replaced with the GAZO as the sputtering target.

### Embodiment 3

This embodiment provides a heterojunction solar cell. Compared with Embodiment 2, the difference only lies in that both the P-type doped amorphous silicon film and the N-type doped amorphous silicon film in this embodiment can contain no microcrystalline silicon.

### Embodiment 4

This embodiment provides a heterojunction solar cell. Compared with Embodiment 2, the difference only lies in that the carrier concentration and thickness of the seed layer and the conductive layer in the TCO film of this embodiment are different from those in Embodiment 2. In this embodiment, in the TCO film on the surface of the N-type doped amorphous silicon film, the carrier concentration of the seed layer may be 5×10²⁰ and the thickness may be 12nm. In this embodiment, in the TCO film on the surface of the P-type doped amorphous silicon film, the carrier concentration of the seed layer may be 1.5×10²⁰ and the thickness may be 12nm.

### Embodiment 5

This embodiment provides a heterojunction solar cell. Compared with Embodiment 2, the difference only lies in that the carrier concentration and thickness of the seed layer and the conductive layer in the TCO film of this embodiment are different from those in Embodiment 2. In this embodiment, in the TCO film on the surface of the N-type doped amorphous silicon film, the carrier concentration of the conductive layer may be 3×10²⁰ and the thickness may be 35nm. In this embodiment, in the TCO film on the surface of the P-type doped amorphous silicon film, the carrier concentration of the conductive layer may be 2.5×10²⁰ and the thickness may be 35nm.

### Comparative Example 1

This comparative example provides a heterojunction solar cell. Compared with Embodiment 2, the difference only lies in that the TCO film of Comparative Example 1 was an ITO film.

### Comparative Example 2

This comparative example provides a heterojunction solar cell. Compared with Embodiment 2, the difference only lies in that the conductive layer of Comparative Example 2 was an ITO film, and the protection layer was a GAZO film.

### Comparative Example 3

This comparative example provides a heterojunction solar cell. Compared with Embodiment 2, the difference only lies in that the TCO film of Comparative Example 3 was a GAZO film.

### Test Example 1

A halm online I-V test system was selected to test, under condition of 25 °C, AM 1.5, and one standard sun, the open circuit voltage (Voc), the short circuit current (Isc), the fill factor (FF) and the conversion efficiency (Eff) of the heterojunction solar cells in Embodiment 1-Embodiment 5 and Comparative Example 1-Comparative Example 3, with the results recorded in Table 1.

**Table 1. Performance Test Results of Heterojunction Solar Cells c**

| | Open circuit voltage (Voc)/V | Short circuit current (Isc)/A | Fill Factor (FF)/% | Conversion efficiency (Eff)/% |
|---|---|---|---|---|
| Embodiment 1 | 0.7452 | 9.386 | 84.23 | 24.11 |
| Embodiment 2 | 0.7456 | 9.389 | 84.35 | 24.17 |
| Embodiment 3 | 0.7448 | 9.343 | 84.05 | 23.94 |
| Embodiment 4 | 0.7451 | 9.385 | 84.26 | 24.10 |
| Embodiment 5 | 0.7456 | 9.399 | 84.03 | 24.10 |
| Comparative Example 1 | 0.7461 | 9.356 | 84.57 | 24.16 |
| Comparative Example 2 | 0.7455 | 9.366 | 84.47 | 24.14 |
| Comparative Example 3 | 0.7445 | 9.398 | 83.56 | 23.93 |

By comparing the experimental results of Embodiment 2, Comparative Example 1 to Comparative Example 3, it can be found that the conversion efficiencies of Comparative Example 1 to Comparative Example 3 are significantly lower than that of Embodiment 2, which shows that the composition of the TCO film in the embodiments of the present application can reduce costs and at the same time, the battery efficiency is guaranteed.

By comparing the experimental results of Embodiment 2, Embodiment 4 and Embodiment 5, it can be found that the conversion efficiency of Embodiment 2 is significantly higher than that of Embodiment 4 and Embodiment 5, which shows that the carrier concentrations and thicknesses of the seed layer and the conductive layer in the TCO film of Embodiment 2 are more conducive to improving the conversion efficiency.

### Test Example 2

The TC200, DH100 and HF10 tests were performed on the heterojunction solar cells of Embodiments 1 to 5 and Comparative Examples 1 to 3, so as to obtain the aging attenuation rates of the heterojunction solar cells during the TC200, DH100 and HF10 tests and the results were recorded in Table 2.

The test condition of TC200 was as follows: the heterojunction solar cell was cycled 200 times between -40 and 85 °C, and Ipm was introduced therein when the temperature exceeded 25 °C.

The test condition for DH100 was as follows: the heterojunction solar cell was tested for 1000h at a temperature of 85±2°C and a humidity of 85%±5%.

The test condition of HF10 was as follows: the heterojunction solar cell was cycled for 10 cycles, between -40 and 85 °C, wherein it was kept stable at the temperature of 85°C for 20 h, and kept at the temperature of -40 °C for 0.5 h for one cycle, and the cycle was of 24 h .

**Table 2. Aging attenuation rate test results of heterojunction solar cells**

| | TC200 (aging attenuation rate) | DH100 (aging attenuation rate) | HF10 (aging attenuation rate) |
|---|---|---|---|
| Embodiment 1 | 2.4% | 3.7% | 2.1% |
| Embodiment 2 | 2.5% | 3.3% | 2.2% |
| Embodiment 3 | 2.3% | 3.5% | 2.3% |
| Embodiment 4 | 2.3% | 3.6% | 2.2% |
| Embodiment 5 | 2.4% | 3.6% | 2.4% |
| Comparative Example 1 | 2.0% | 3.0% | 1.9% |
| Comparative Example 2 | 2.3% | 3.7% | 2.4% |
| Comparative Example 3 | 3.5% | 7.8% | 3.3% |

By comparing the experimental results of Embodiment 2 with Comparative Example 2 and Comparative Example 3, it can be found that the aging attenuation rate of Comparative Example 3 is significantly higher than that of Embodiment 2, and the aging attenuation rates corresponding to DH100 and HF10 of Comparative Example 2 are significantly higher than those of Embodiment 2, which shows that the composition of the TCO film in the embodiments of the present application can reduce the cost and decrease the battery attenuation.

Only preferred embodiments of the present application are given in the above description, which is not intended to limit the present application. For those skilled in the art, the present application may have various modifications and changes. Any modifications, equivalent replacements, improvements, etc., made within the spirit and principle of the present application, shall be included within the protection scope of this application.

### Industrial Applicability

The present application provides a transparent conductive oxide film and a heterojunction solar cell. The transparent conductive oxide film comprises a seed layer, a conductive layer and a protective layer, wherein the seed layer comprises an indium tin oxide film or a gallium/aluminum co-doped zinc oxide film, the conductive layer is a gallium/aluminum co-doped zinc oxide film, and the protective layer is an indium tin oxide film. The thickness of the indium tin oxide film in the transparent conductive oxide film is smaller than the thickness of the gallium/aluminum co-doped zinc oxide film. It can ensure battery efficiency and reduce battery attenuation, while reducing costs.

Furthermore, it can be understood that the transparent conductive oxide film and the heterojunction solar cell of the present application are reproducible and can be used in a variety of industrial applications. For example, the transparent conductive oxide film and the heterojunction solar cell of the present application can be used in the field of solar cell technology.

## Claims

1. A transparent conductive oxide film, **characterized by** comprising a seed layer, a conductive layer and a protection layer, wherein the seed layer comprises an indium tin oxide film or a gallium/aluminum co-doped zinc oxide film, the conductive layer is a gallium/aluminum co-doped zinc oxide film, and the protection layer is an indium tin oxide film; and
the indium tin oxide film in the transparent conductive oxide film has a thickness smaller than that of the gallium/aluminum co-doped zinc oxide film.

2. A heterojunction solar cell, **characterized by** comprising:
a silicon wafer;
intrinsic amorphous silicon films, on both surfaces of the silicon wafer;
a P-type doped amorphous silicon film and an N-type doped amorphous silicon film, with the P-type doped amorphous silicon film located on a surface of one of the intrinsic amorphous silicon films, and the N-type doped amorphous silicon film located on a surface of the other intrinsic amorphous silicon film;
the transparent conductive oxide film according to claim 1, wherein the transparent conductive oxide film is provided on surfaces of the P-type doped amorphous silicon film and the N-type doped amorphous silicon film, and the seed layer is provided close to the P-type doped amorphous silicon film and the N-type doped amorphous silicon film; and
an electrode, wherein the electrode is arranged on a surface of the transparent conductive oxide film.

3. The heterojunction solar cell according to claim 2, wherein the silicon wafer is a single crystal silicon wafer.

4. The heterojunction solar cell according to claim 2 or 3, wherein in the transparent conductive oxide film on the surface of the N-type doped amorphous silicon film, the seed layer has a carrier concentration > 6 × 10²⁰, and a thickness <10nm.

5. The heterojunction solar cell according to any one of claims 2 to 4, wherein in the transparent conductive oxide film on the surface of the N-type doped amorphous silicon film, the conductive layer has a carrier concentration < 2 × 10²⁰, and a thickness > 40nm.

6. The heterojunction solar cell according to claim 5, wherein the transparent conductive oxide film on the surface of the N-type doped amorphous silicon film has a thickness of 60nm - 150nm.

7. The heterojunction solar cell according to any one of claims 2 to 6, wherein in the transparent conductive oxide film on the surface of the P-type doped amorphous silicon film, the seed layer has a carrier concentration <1 × 10²⁰, and a thickness <10nm.

8. The heterojunction solar cell according to claim 2 or 7, wherein in the transparent conductive oxide film on the surface of the P-type doped amorphous silicon film, the conductive layer has a carrier concentration >3 × 10²⁰, and a thickness >40nm.

9. The heterojunction solar cell according to claim 8, wherein the transparent conductive oxide film on the surface of the P-type doped amorphous silicon film has a thickness of 60nm - 250nm.

10. The heterojunction solar cell according to any one of claims 2 to 9, wherein both the P-type doped amorphous silicon film and the N-type doped amorphous silicon film have microcrystalline silicon.

11. The heterojunction solar cell according to any one of claims 2 to 10, wherein the P-type doped amorphous silicon film has a crystallization rate > 20%; and/or the N-type doped amorphous silicon film has a crystallization rate > 25%.

12. The heterojunction solar cell according to any one of claims 2 to 9, wherein the P-type doped amorphous silicon film and the N-type doped amorphous silicon film contain no microcrystalline silicon.

13. The heterojunction solar cell according to claim 2 or 3, wherein in the transparent oxide film on the surface of the N-type doped amorphous silicon film, the seed layer has a carrier concentration of 5×10²⁰, and a thickness of 12nm, or the conductive layer has a carrier concentration of 3×10²⁰ and a thickness of 35nm.

14. The heterojunction solar cell according to claim 2 or 3, wherein in the transparent oxide film on the surface of the P-type doped amorphous silicon film, the seed layer has a carrier concentration of 1.5×10²⁰ and a thickness of 12nm, or the conductive layer has a carrier concentration of 2.5×10²⁰ and a thickness of 35nm.
